# EUROPEAN PATENT APPLICATION

(11) **EP 4 819 825 A2**
(43) Date of publication of application: **07.10.2026**
(21) Application number: 26157339.8
(22) Date of filing: 09.02.2026
(51) Int. Cl.: H10W 90/20, H10W 74/10, H10W 90/00, H10W 90/28

(54) **SEMICONDUCTOR PACKAGE INCLUDING POWER SUPPLY CAPACITOR**

(30) Priority: 03.04.2025 KR 20250043691
(71) Applicant: Samsung Electronics Co., Ltd., Suwon-si, Gyeonggi-do 16677 (KR)
(72) Inventor: KIM, Kilsoo, 16677 Suwon-si (KR)
(74) Representative: Marks & Clerk LLP

(57) **Abstract**

A semiconductor package including a first semiconductor chip, a plurality of second semiconductor chips stacked on the first semiconductor chip in a first direction perpendicular to an upper surface of the first semiconductor chip, an upper semiconductor chip stacked on the uppermost second semiconductor chip among the plurality of second semiconductor chips, and a dummy semiconductor chip stacked on the upper semiconductor chip and including a capacitor. The upper semiconductor chip includes an upper through via that passes through at least a portion of the upper semiconductor chip and is electrically connected to the capacitor.

## Description

### BACKGROUND

### 1. Field

Example embodiments relate to a semiconductor package.

### 2. Description of the Related Art

Semiconductor packaging techniques have evolved to meet the demand for smaller sizes and higher capacity. In recent years, various methods for manufacturing stacked semiconductor packages with reduced size, increased capacity, and improved mounting efficiency have been developed.

Additionally, techniques for three-dimensional stacking of multiple semiconductor chips have been developed. The Through Silicon Via (TSV) technique, which pass through the silicon substrate to connect between the elements of the semiconductor package with short connection wiring, has been developed.

In three-dimensional stacking structure, thermal resistance may increase and power supply issues may occur as the number of layers stacked increases. When power is supplied through the base chip located at the bottom, the power supply path in the base chip is highly stressed, and may reduce efficiency of supplying power to the upper semiconductor chips. To address these issues, techniques that enable stable power supply to stacked semiconductor chips are required.

### SUMMARY

An aspect provides a semiconductor package for enhancing power supply efficiency.

An aspect also provides a semiconductor package for enhancing thermal characteristics by reducing thermal resistance.

However, the goals to be achieved by example embodiments of the present disclosure are not limited to the objects described above and other objects may be clearly understood from the following description by those skilled in the art.

According to an aspect, there is provided a semiconductor package including a first semiconductor chip, a plurality of second semiconductor chips stacked on the first semiconductor chip in a first direction perpendicular to an upper surface of the first semiconductor chip, an upper semiconductor chip stacked on the uppermost second semiconductor chip among the plurality of second semiconductor chips, and a dummy semiconductor chip stacked on the upper semiconductor chip and including a capacitor. The upper semiconductor chip comprises an upper through via electrically connected to the capacitor.

According to another aspect, there is provided a semiconductor package including a first semiconductor chip, a plurality of second semiconductor chips stacked on the first semiconductor chip in a first direction perpendicular to an upper surface of the first semiconductor chip, a connection terminal disposed on a lower surface of the first semiconductor chip, an upper semiconductor chip stacked on the uppermost second semiconductor chip among the plurality of second semiconductor chips, a dummy semiconductor chip stacked on the upper semiconductor chip and including a capacitor, and a molding layer surrounding the plurality of second semiconductor chips, the upper semiconductor chip, and the dummy semiconductor chip. Each of the plurality of second semiconductor chips includes a plurality of second through vias including power/ground through vias configured to transmit a power voltage or a ground voltage between the first semiconductor chip and the plurality of second semiconductor chips, the upper semiconductor chip includes an upper semiconductor substrate and an upper through via electrically connected to at least one of the power/ground through vias and disposed in the upper semiconductor substrate, and the capacitor is electrically connected to the upper through via.

According to still another aspect, there is also provided a semiconductor package including a first semiconductor chip, a connection terminal disposed on a lower surface of the first semiconductor chip, a plurality of second semiconductor chips stacked on the first semiconductor chip in a first direction perpendicular to an upper surface of the first semiconductor chip, an upper semiconductor chip stacked on an uppermost second semiconductor chip among the plurality of second semiconductor chips, a dummy semiconductor chip comprising a dummy semiconductor substrate stacked on the upper semiconductor chip, a dummy bonding layer, and a capacitor disposed between the dummy semiconductor substrate and the dummy bonding layer and connected to the upper semiconductor chip, and a molding layer surrounding the plurality of second semiconductor chips, the upper semiconductor chip, and the dummy semiconductor chip. The first semiconductor chip includes a first semiconductor substrate, a first bonding layer on a lower surface of the first semiconductor substrate, a second bonding layer on an upper surface of the first semiconductor substrate, and a plurality of first through vias disposed in the first semiconductor substrate. Each semiconductor chip of the plurality of second semiconductor chips includes a second semiconductor substrate, a second chip wiring layer, a plurality of second through vias disposed in the second semiconductor substrate, a third bonding layer on a lower surface of the semiconductor chip, and a fourth bonding layer on an upper surface of the semiconductor chip. The plurality of second through vias include power/ground through vias configured to transmit a power voltage or a ground voltage between the first semiconductor chip and the plurality of second semiconductor chips and a signal through via configured to transmit information. The upper semiconductor chip includes an upper semiconductor substrate, a first upper bonding layer in contact with the uppermost second semiconductor chip among the plurality of second semiconductor chips, a second upper bonding layer in contact with the dummy semiconductor chip, and an upper through via disposed in the upper semiconductor substrate and electrically connected to the capacitor and at least one of the power through vias of each semiconductor chip of the plurality of second semiconductor chips.

According to yet another aspect, there is provided a method of manufacturing a semiconductor package, the method including forming a first semiconductor chip, stacking a plurality of second semiconductor chips on the first semiconductor chip, each of the plurality of second semiconductor chips including a second semiconductor substrate and a plurality of second through vias disposed in the second semiconductor substrate, stacking an upper semiconductor chip on the uppermost second semiconductor chip of the plurality of second semiconductor chips, the upper semiconductor chip including an upper semiconductor substrate and an upper through via disposed in the upper semiconductor substrate, , and stacking a dummy semiconductor chip that includes a capacitor on the upper semiconductor chip. The plurality of second through vias include power/ground through vias that transmits a power voltage or a ground voltage and a signal through via that transmits information, and the capacitor is connected to at least one of the power/ground through vias through the upper through via.

According to still another aspect, a method of manufacturing a semiconductor package may further include forming a first upper bonding layer disposed on a lower surface of the upper semiconductor substrate, a second upper bonding layer disposed on an upper surface of the upper semiconductor substrate and in contact with the dummy semiconductor chip, and a second upper bonding pad surrounded by the second upper bonding layer and forming a dummy bonding layer disposed below the capacitor and a fifth bonding pad surrounded by the dummy bonding layer, and the capacitor is connected to the upper through via through the fifth bonding pad and the second upper bonding pad.

According to yet another aspect a method of manufacturing a semiconductor package may further include forming a molding layer surrounding the first semiconductor chip, the plurality of second semiconductor chips, and the dummy semiconductor chip, and an upper surface of the dummy semiconductor chip is disposed coplanar with an upper surface of the molding layer.

Detailed descriptions of other example embodiments are included in the detailed description and drawings.

Effects obtainable through the present disclosure are not limited to those described above, and other effects may be made apparent to those skilled in the art from the following description.

At least some of the above and other features of the invention are set out in the claims.

### BRIEF DESCRIPTION OF THE FIGURES

These and/or other aspects, features, and advantages of the invention will become apparent and more readily appreciated from the following description of example embodiments, taken in conjunction with the accompanying drawings of which:
FIG. 1 is a cross-sectional view of a semiconductor package according to example embodiments;
FIG. 2 is an enlarged view of section P of FIG. 1;
FIG. 3 is a cross-sectional view of a semiconductor package according to example embodiments;
FIG. 4 is a cross-sectional view of a semiconductor package according to example embodiments;
FIG. 5 is a cross-sectional view of a semiconductor package according to example embodiments; and
FIGS. 6 through 11 diagrams illustrating a manufacturing process of a semiconductor package according to example embodiments.

### DETAILED DESCRIPTION

The present disclosure now will be described more fully hereinafter with reference to the accompanying drawings, in which various embodiments are shown. The invention may, however, be embodied in many different forms and should not be construed as limited to the example embodiments set forth herein. It should also be emphasized that the disclosure provides details of alternative examples, but such listing of alternatives is not exhaustive. Furthermore, any consistency of detail between various examples should not be interpreted as requiring such detail. The terms and words used in the present disclosure and the accompanying claims are not to be limited to general definitions or dictionary definitions, and the terms and words are to be construed under the principle that an inventor may appropriately define a concept of a term in order to describe their invention in the best way.

In the following descriptions, the identification of an item in a singular form does not limit the item to a single instance and there may be a multiple instances of the item and the description of the item may be applicable to all of the instances, unless the context clearly indicates otherwise. Terms such as "including" or "comprising" indicate that a feature, a number, an operation, an action, an element, a component, or a combination thereof is present, but it should be understood that one or more other features, numbers, operations, actions, elements, components, or combinations thereof may be present or added.

In the present disclosure, ordinal terms such as "first" and "second" may be used to describe various elements throughout the specification. However, elements that are not described using "first," "second," etc., in the specification, may still be referred to as "first" or "second" in a claim. In addition, an element that is referenced with a particular ordinal number (e.g., "first" in a particular claim) may be referenced elsewhere without an ordinal number or with a different ordinal number (e.g., "second" in the specification or another claim). In general, ordinal terms such as "first" and "second" are labels intended to distinguish one element from another. Accordingly, these terms need not imply any particular order or importance.

In the following description, it should be noted that expressions such as an upper side, an upper surface, a lower side, a lower surface, a side surface, a front surface, or a rear surface is based on directions illustrated in the drawings and that these expressions may change when a relative orientation of a corresponding object changes. These relative positions may be defined relative to the structure of the device. For instance, a vertical direction may be defined perpendicular to one or more substrates (e.g., to an upper or lower surface of one or more substrates). The shapes and sizes of the elements in the drawings may be exaggerated for clarity or emphasis. Like numbers refer to like elements throughout.

Terms such as "same," "equal," "planar," "coplanar," "parallel," and "perpendicular," as used herein encompass identicality or near identicality including variations that may occur resulting from conventional manufacturing processes. The term "substantially" may be used herein to emphasize this meaning, unless the context or other statements indicate otherwise.

As used herein, the singular forms "a", "an", and "the" are intended to include the plural forms as well, unless the context clearly indicates otherwise. Additionally, the description may be specific to a portion of the semiconductor device and the described structure may be repeated in other portions of the semiconductor device. For example, the described structure may be an individual element of an array of elements forming the semiconductor device. Accordingly, where the structure of a single element of a plurality of elements has been described, this structure may equally apply to other elements of the plurality of elements.

The term "overlap" (or "overlapping", or like terms), as may be used herein, is intended to broadly refer to a first element that intersects with at least a portion of a second element in the a particular direction (i.e., in a first direction D1, perpendicular to the upper surface of a substrate), but does not require that the first and second elements be completely aligned with one another; that is, components or layers described with reference to "overlap" in a particular direction may be at least partially obstructed by one another when viewed along a line extending in the particular direction.

The various pads of a device described herein may be conductive terminals connected to internal wiring of the device, and may transmit signals and/or supply voltages between an internal wiring and/or internal circuit of the device and an external source. The various pads may be provided on or near an external surface of the device and may have a planar surface having dimensions greater than wiring (e.g., X-Y horizontal dimensions of a pad are both greater than the width of an internal wiring to which it is connected) to promote an electrical connection to a further terminal, such as a bump or solder ball, and/or an external wiring.

As used herein, the term "dummy" is used to refer to a component that may have the same or similar shape and/or structure as a component having the same name without the "dummy" descriptor, but that does not have the same substantial function (e.g., to convey signals). In some instances, a "dummy" element may be electrically floated, or may be connected to various voltage sources but otherwise not provide the same functionality of the non-dummy element it represents. For example, a dummy pad may not be electrically connected to a wiring, or a dummy chip may not include active semiconductor devices.

It will be understood that when an element is referred to as being "connected" or "coupled" to or "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact.

As used herein, components described as being "electrically connected" are configured such that an electrical signal can be transferred from one component to the other (although such electrical signal may be attenuated in strength as it is transferred and may be selectively transferred). Moreover, components that are "directly electrically connected" form a common electrical node through electrical connections by one or more conductors, such as, for example, wires, pads, internal electrical lines, through vias, etc. As such, directly electrically connected components do not include components electrically connected through active elements, such as transistors or diodes.

Hereinafter, example embodiments according to the technical spirit of the present disclosure will be described with reference to the drawings.

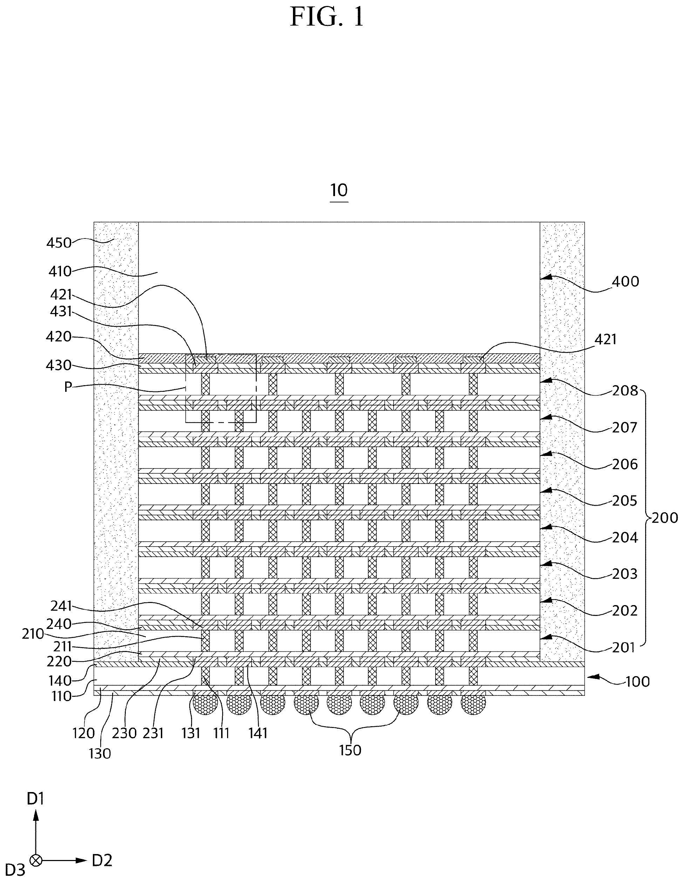

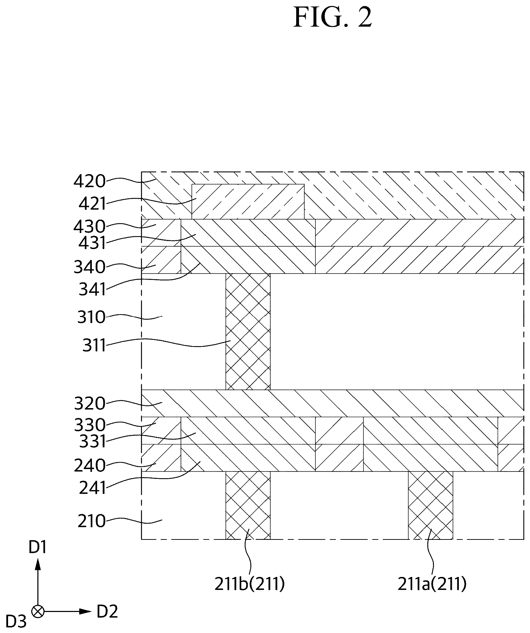

FIG. 1 illustrates a semiconductor package 10 according to example embodiments, and FIG. 2 is an enlarged view of section P of FIG. 1.

Referring to FIGS. 1 and 2, the semiconductor package 10 according to example embodiments may include a first semiconductor chip 100, connection terminals 150, a plurality of second semiconductor chips 201 to 207, an upper semiconductor chip 208, a dummy semiconductor chip 400, and a molding layer 450.

According to example embodiments, a first direction D1 may refer to a direction intersecting with an upper surface of the first semiconductor chip 100 and that is a direction in which the first semiconductor chip 100, a chip stack 200 and the dummy semiconductor chip 400 are stacked on one another. For example, the first direction D1 may be a direction perpendicular to the upper surface of the first semiconductor chip 100. A second direction D2 may refer to a direction parallel to the upper surface of the first semiconductor chip 100 and intersecting with the first direction D1. A third direction D3 may refer to a direction intersecting with the first and second directions D1 and D2. The first and second directions D1 and D2, the second and third directions D2 and D3, and the first and third directions D1 and D3 may each be perpendicular to one another.

The first semiconductor chip 100 may include a first semiconductor substrate 110, first through vias 111, a first chip wiring layer 120, a first bonding layer 130, and a second bonding layer 140.

The first semiconductor substrate 110 may include an upper surface and a lower surface that are opposite to one another. The upper surface of the first semiconductor substrate 110 may be an upper surface in the first direction D1, and the lower surface of the first semiconductor substrate 110 may be a lower surface in the first direction D1. The upper surface of the first semiconductor substrate 110 may be a surface facing the chip stack 200. The lower surface of the first semiconductor substrate 110 may be a surface on which the first chip wiring layer 120 is formed.

The first semiconductor substrate 110 may include silicon (Si). However, the material the first semiconductor substrate 110 is made of is not limited thereto. For example, the first semiconductor substrate 110 may include another semiconductor material such as germanium (Ge), silicon-germanium (Ge-Si), or III-V group compound such as gallium phosphide (GaP), gallium arsenide (GaAs), and gallium antimonide (GaSb). For example, the first semiconductor substrate 110 may be a silicon-on-insulator (SOI) substrate or a germanium-on-insulator (GOI) substrate.

The first through vias 111 may be disposed in the first semiconductor substrate 110. The first through vias 111 may pass through the first semiconductor substrate 110 and be connected to the first chip wiring layer 120. For example, the first through vias 111 may be connected to the first chip wiring layer 120 and second bonding pads 141. For example, an upper part of each of the first through vias 111 may be connected to a respective one of the second bonding pads 141, and a lower part of each of first through vias 111 may be connected to the first chip wiring layer 120.

A first through vias 111 may have a cylindrical form. For example, the first through via 111 may be formed as a Through Silicon Via (TSV) in the first semiconductor chip 100. For example, the first through via 111 may include copper (Cu), aluminum (Al), or tungsten (W), but this is merely an example.

The first chip wiring layer 120 may include a semiconductor device and may have a circuit structure electrically connected to the semiconductor device. Although not shown in detail, the first chip wiring layer 120 may have a multilayer wiring structure including a plurality of wiring patterns located at different levels and a plurality of wiring vias.

The first chip wiring layer 120 may include various types of electronic devices. For example, the first chip wiring layer 120 may include a metal-oxide-semiconductor field-effect transistor (MOSFET) such as a complementary metal-oxide-semiconductor (CMOS) transistor, system large-scale integration (LSI), flash memory, dynamic random-access memory (DRAM), static random-access memory (SRAM), electrically erasable programmable read-only memory (EEPROM), phase-change random-access memory (PRAM), magnetic random-access memory (MRAM), or resistive RAM (RERAM), image sensor such as CMOS image sensor (CIS), micro-electromechanical systems (MEMS), active device, passive device, and the like.

The first bonding layer 130 may be disposed below the first semiconductor substrate 110 and on a lower surface of the first chip wiring layer 120. The first bonding layer 130 may be disposed below the first chip wiring layer 120. The first bonding layer 130 may surround first bonding pads 131 connected to a respective one of the connection terminals 150.

The first bonding layer 130 may surround the first bonding pads 131. The first bonding pads 131 may each be electrically connected to a corresponding first through via 111. The first bonding pads 131 may be a plurality of bonding pads that are spaced apart from one another in the second direction D2 or third direction D3.

The second bonding layer 140 may be disposed on the upper surface of the first semiconductor substrate 110. The second bonding layer 140 may surround second bonding pads 141. The second bonding pads 141 may each be electrically connected to a corresponding first through via 111. The second bonding pads 141 may be connected to a lowermost second semiconductor chip 201 among the plurality of second semiconductor chips 201 to 207. The second bonding pads 141 may include a plurality of bonding pads that are spaced apart from one another in the second direction D2 or third direction D3.

The first bonding layer 130 and the second bonding layer 140 may include a material including at least one of silicon monoxide (SiO), silicon nitride (SiN), silicon carbon nitride (SiCN), silicon carbon monoxide (SiCO), and polymer. The first and second bonding pads 131 and 141 may include a conductive material such as copper (Cu), aluminum (Al), or tungsten (W), but this is merely an example.

The connection terminals 150 may be disposed on a lower surface of the first semiconductor chip 100. The connection terminals 150 may be disposed below the first bonding pads 131. The connection terminals 150 may each be electrically connected to a corresponding one of the first bonding pads 131. The semiconductor package 10 may be electrically connected to an external element through the connection terminals 150. For example, the connection terminals 150 may be electrically connected to an external voltage source and supply power to the chip stack 200 through the first bonding pads 131, the first chip wiring layer 120, the first through vias 111, and the second bonding pads 141.

The connection terminals 150 may include at least one of a solder ball, a bump, an under bump metallurgy (UBM), and the like, but this is merely an example.

The chip stack 200 may include the plurality of second semiconductor chips 201 to 207 and the upper semiconductor chip 208. The number of semiconductor chips included in the chip stack 200 shown and described in the present disclosure is for illustrative purposes only and is not to be construed as limiting.

The plurality of second semiconductor chips 201 to 207 may be stacked on the first semiconductor chip 100 in the first direction D1 intersecting with the upper surface of the first semiconductor chip 100. A thickness of each of the plurality of second semiconductor chips 201 to 207 in the first direction D1 and a thickness of the upper semiconductor chip 208 in the first direction D1 may be the same. Each of the plurality of second semiconductor chips 201 to 207 may include a second semiconductor substrate 210, a second through vias 211, a second chip wiring layer 220, a third bonding layer 230, and a fourth bonding layer 240.

The second semiconductor substrate 210 may include an upper surface and a lower surface that are opposite to one another. The upper surface of the second semiconductor substrate 210 may be an upper surface in the first direction D1, and the lower surface of the second semiconductor substrate 210 may be a lower surface in the first direction D1. The upper surface of the second semiconductor substrate 210 may be a surface facing the dummy semiconductor chip 400. The lower surface of the second semiconductor substrate 210 may be a surface on which the second chip wiring layer 220 is formed.

The second semiconductor substrate 210 may include silicon (Si). However, the material the second semiconductor substrate 210 is made of is not limited thereto. For example, the second semiconductor substrate 210 may include another semiconductor material such as germanium (Ge), silicon-germanium (Ge-Si), or III-V group compound such as gallium phosphide (GaP), gallium arsenide (GaAs), and gallium antimonide (GaSb). For example, the second semiconductor substrate 210 may be a silicon-on-insulator (SOI) substrate or a germanium-on-insulator (GOI) substrate.

The second through vias 211 may be disposed in the second semiconductor substrate 210. The second through vias 211 may pass through the second semiconductor substrate 210 and be connected to the second chip wiring layer 220. For example, the second through vias 211 may be connected to the second chip wiring layer 220 and fourth bonding pads 241. For example, an upper part of each of the second through vias 211 may be connected to a corresponding one of the fourth bonding pads 241, and a lower part of each of the second through vias 211 may be connected to the second chip wiring layer 220.

A second through via 211 may have a cylindrical form. For example, the second through via 211 may be formed as a Through Silicon Via (TSV) in the second semiconductor chips 201 to 207. For example, the second through via 211 may include a conductive material such as copper (Cu), aluminum (Al), or tungsten (W), but this is merely an example.

The second through vias 211 may include a signal through via 211a and power/ground through vias 211b. The signal through via 211a may transmit data information such as data, address, and/or control/command information between the first semiconductor chip 100 and the chip stack 200. The power/ground through vias 211b may transmit a power voltage or a ground voltage between the first semiconductor chip 100 and the chip stack 200. For example, the power/ground through vias 211b may be power through vias for supplying a power voltage or ground through vias for supplying a ground voltage. For example, the power/ground through vias 211b may be connected to a voltage supply for the semiconductor package or an internal voltage regulator. The signal through via 211a and the power/ground through vias 211b may be distinguished from one another either due to the voltage/signals that they receive, or due to the circuits that they provide their respective voltage/signals to. For instance, a signal through via 211a may be configured to supply a signal to one or more signal processing components within the device. For instance, a signal through via 211a may be connected to one or more gates of one or more transistors. Similarly, power/ground through vias 211b may be connected to a power distribution component within the device (e.g., through the capacitor 241). For instance the capacitor may be connected to one or more power supply lines within the upper part of the chip stack 200. For instance, the capacitor 241 may be connected to one or more sources and/or one or more drains of one or more transistors within the device.

At least one of the second through vias 211 may be connected to a corresponding one of the upper through vias 311 and a capacitor 421. For example, the power/ground through vias 211b may be connected to a corresponding one of the upper through vias 311 and the capacitor 421. Additionally, at least one of the first through vias 111 and a corresponding one of the connection terminals 150 may be connected to the capacitor 421 through the power/ground through vias 211b. Accordingly, it is possible to enhance power supply efficiency of the semiconductor package 10. Also, it is possible to enhance thermal characteristics by reducing electrical resistance of the semiconductor package 10.

The second chip wiring layer 220 may include various types of electronic devices. For example, the second chip wiring layer 220 may include a metal-oxide-semiconductor field-effect transistor (MOSFET) such as a complementary metal-oxide-semiconductor (CMOS) transistor, system large-scale integration (LSI), flash memory, dynamic random-access memory (DRAM), static random-access memory (SRAM), electrically erasable programmable read-only memory (EEPROM), phase-change random-access memory (PRAM), magnetic random-access memory (MRAM) or resistive RAM (RERAM), image sensor such as CMOS image sensor (CIS), micro-electromechanical systems (MEMS), active device, passive device, and the like.

The third bonding layer 230 may be disposed below the second semiconductor substrate 210 and on a lower surface of the second chip wiring layer 220. The third bonding layer 230 may be disposed below the second chip wiring layer 220.

The third bonding layer 230 may surround third bonding pads 231. The third bonding pads 231 may be electrically connected to the second through vias 211. For example, each of the third bonding pads 231 may be electrically connected to a corresponding one of the second through vias 211. The third bonding pads 231 may include a plurality of bonding pads that are spaced apart from one another in the second direction D2 or third direction D3.

The fourth bonding layer 240 may be disposed on an upper surface of the second semiconductor substrate 210. The fourth bonding layer 240 may surround fourth bonding pads 241. The fourth bonding pads 241 may be electrically connected to the second through vias 211. For example, each fourth bonding pad 241 may be electrically connected to a corresponding second through via 211. The fourth bonding pads 241 may include a plurality of bonding pads that are spaced apart from one another in the second direction D2 or third direction D3.

The third bonding layer 230 and the fourth bonding layer 240 may include at least one material of silicon monoxide (SiO), silicon nitride (SiN), silicon carbon nitride (SiCN), silicon carbon monoxide (SiCO), and polymer. For example, the third and fourth bonding pads 231 and 241 may include copper (Cu), aluminum (Al), or tungsten (W), but this is merely an example.

The plurality of second semiconductor chips 201 to 207 may be bonded to one another. Adjacent third and fourth bonding layers 230 and 240 within the chip stack 200 may be in contact with each other and bonded together. The plurality of second semiconductor chips 201 to 207 adjacent to one another in the first direction D1 may be electrically connected through the third and fourth bonding pads 231 and 241.

The upper semiconductor chip 208 may be disposed on an uppermost second semiconductor chip 207 among the plurality of second semiconductor chips 201 to 207. The upper semiconductor chip 208 may include an upper semiconductor substrate 310, upper through vias 311, a first upper bonding layer 330, and a second upper bonding layer 340.

The dummy semiconductor chip 400 may be disposed on an upper surface of the upper semiconductor substrate 310, and the plurality of second semiconductor chips 201 to 207 may be disposed on a lower surface of the upper semiconductor substrate 310. The upper semiconductor substrate 310 may include silicon (Si). However, the material the upper semiconductor substrate 310 is made of is not limited thereto. For example, the upper semiconductor substrate 310 may include another semiconductor material such as germanium (Ge), silicon-germanium (Ge-Si), or III-V group compound such as gallium phosphide (GaP), gallium arsenide (GaAs), and gallium antimonide (GaSb). For example, the upper semiconductor substrate 310 may be a silicon-on-insulator (SOI) substrate or a germanium-on-insulator (GOI) substrate.

The upper through vias 311 may be disposed in the upper semiconductor substrate 310. The upper through vias 311 may pass through at least a portion of the upper semiconductor chip 208. The upper through vias 311 may be connected to corresponding second through vias 211. For example, an upper through via 311 may be connected to at least one of a power/ground through vias 211b among the second through vias 211. When an upper through via 311 is connected to a signal through via 211a, a data signal transmitted through the signal through via 211a may be lost due to a stub effect. Therefore, the upper through vias 311 may not be connected to the signal through vias 211a, but this is merely an example.

The upper through vias 311 may each overlap with a corresponding power/ground through vias 211b in the first direction D1. The upper through vias 311 may be formed to correspond to one of the second through vias 211 of the uppermost second semiconductor chip 207 among the plurality of second semiconductor chips 201 to 207. The upper semiconductor substrate 310 may be disposed in a region of the upper semiconductor chip 208 corresponding to at least one of the second through vias 211 in which a corresponding upper through via 311 is not formed. For example, the upper semiconductor substrate 310 may be disposed to overlap at least one signal through via 211a.

The upper through via 311 may have a cylindrical form. For example, the upper through vias 311 may be formed as Through Silicon Vias (TSV) in the upper semiconductor chip 208. For example, the upper through vias 311 may include a conductive material such as copper (Cu), aluminum (Al), or tungsten (W), but this is merely an example.

The first upper bonding layer 330 may be disposed below the upper semiconductor substrate 310 and on a lower surface of the upper chip wiring layer 320. The first upper bonding layer 330 may surround first upper bonding pads 331.

The first upper bonding pads 331 may include a plurality of bonding pads that are spaced apart from one another in the second direction D2 or third direction D3. As an example, the first upper bonding pads 331 may overlap with corresponding second through vias 211 in the first direction D1. As another example, the first upper bonding pads 331 may overlap with corresponding third bonding pads 231 and corresponding fourth bonding pads 241 in the first direction D1. For example, each first upper bonding pad 331 may be connected to a fourth bonding pad 241 of the uppermost second semiconductor chip 207 among the plurality of second semiconductor chips 201 to 207.

The second upper bonding layer 340 may be disposed on the upper surface of the upper semiconductor substrate 310. The second upper bonding layer 340 may include second upper bonding pads 341. The second upper bonding pads 341 may include a plurality of bonding pads that are spaced apart from one another in the second direction D2 or third direction D3. The second upper bonding pads 341 may be formed to overlap with corresponding ones of the first upper bonding pads 331 in the first direction D1. The second upper bonding pads 341 may each be connected to at least one first upper bonding pad 331 through a corresponding one of the upper through vias 311. The second upper bonding pads 341 may each be connected to at least one of a power/ground through vias 211b, at least one first through via 111, and at least one of the connection terminals 150 through an upper through via 311.

The dummy semiconductor chip 400 may be disposed on the upper semiconductor chip 208. For example, a width of the dummy semiconductor chip 400 may be the same as that of the chip stack 200 in the second direction D2. The dummy semiconductor chip 400 may include a dummy semiconductor substrate 410, an upper wiring layer 420, and a dummy bonding layer 430.

The dummy semiconductor substrate 410 may be formed to be thicker than the second semiconductor substrate 210 and the upper semiconductor substrate 310 in the first direction D1. An upper surface of the dummy semiconductor substrate 410 may be disposed on the same plane as an upper surface of the molding layer 450 (e.g., they may be coplanar). Heat generated within the semiconductor package 10 may be released to the outside of the semiconductor package 10 through the dummy semiconductor substrate 410.

The upper wiring layer 420 may be disposed between the dummy semiconductor substrate 410 and the upper semiconductor chip 208. When power is supplied to the chip stack 200 through the connection terminals 150, it may be difficult to supply power to the upper part of the chip stack 200. The upper wiring layer 420 may include the capacitor 421 disposed below the dummy semiconductor substrate 410 to improve the supply of power to the upper part of the chip stack 200.

The capacitor 421 may be connected to a fifth bonding pad 431 of the dummy bonding layer 430 which is disposed below the upper wiring layer 420. The fifth bonding pad 431 may be disposed to overlap with one of the second upper bonding pads 341 in the first direction at a location corresponding to the second upper bonding pad 341. The fifth bonding pad 431 may electrically connect the capacitor 421 to the second upper bonding pad 341. The capacitor 421 may supply power to a semiconductor chip disposed in the upper part of the chip stack 200.

The molding layer 450 may be disposed on the first semiconductor chip 100. The molding layer 450 may cover a portion of the upper surface of the first semiconductor chip 100. The molding layer 450 may surround a side surface of the chip stack 200 and a side surface of the dummy semiconductor chip 400. The upper surface of the molding layer 450 may be disposed on the same plane as an upper surface of the dummy semiconductor chip 400. For example, the molding layer 450 may include epoxy molding compound (EMC), but this is merely an example.

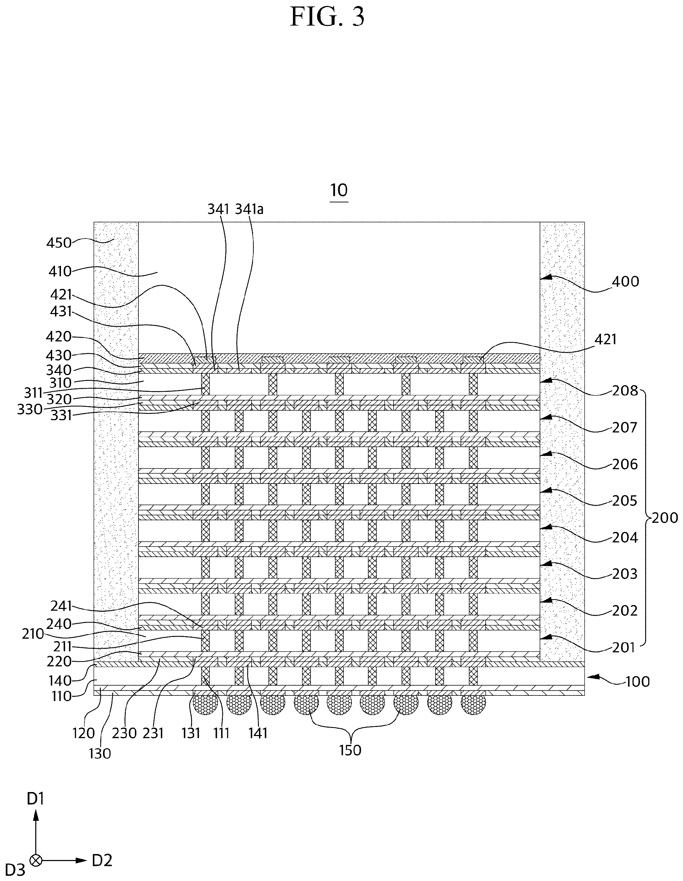

FIGS. 3 through 5 illustrate a semiconductor package according to example embodiments different from that of FIG. 1. Elements that are the same, substantially the same, or similar to those described previously may be identified by the same reference numbers and the description of such elements may be omitted or limited with the understanding that the previous description is applicable. The description related to FIGS. 3 through 5 will primarily focus on differences from the example embodiment shown in FIG. 1.

Referring to FIG. 3, first dummy bonding pads 341a may be included in the second upper bonding layer 340. The first dummy bonding pads 341a may correspond to the first upper bonding pads 331 and may be disposed in a region where the second upper bonding pads 341 are not disposed in the second upper bonding layer 340. For example, the first dummy bonding pads 341a may each overlap, in the first direction D1, with a first upper bonding pad 331, among the first upper bonding pads 331, that does not correspond to (e.g., overlap) a second upper bonding pad 341.

The bonding pads 341 and 341a of the second upper bonding layer 340 may be formed in regions overlapping with the fourth bonding pads 241 of the fourth bonding layer 240 in the first direction D1.

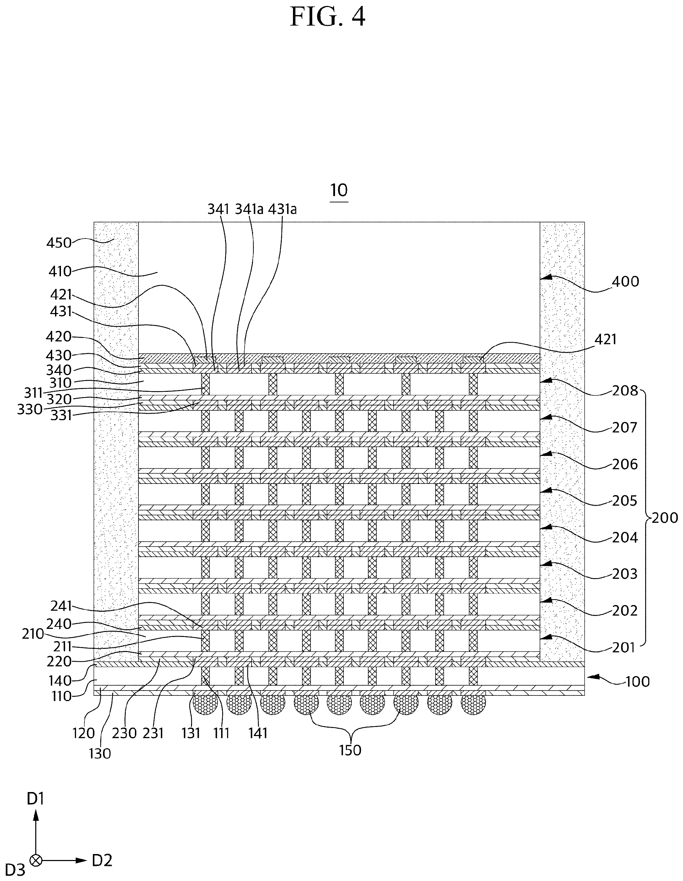

Referring to FIG. 4, second dummy bonding pads 431a may also be disposed in the dummy bonding layer 430. The second dummy bonding pads 431a may be disposed in a region corresponding to the first upper bonding pads 331 and in which the fifth bonding pads 431 are not disposed. For example, the second dummy bonding pads 431a may each overlap, in the first direction D1, with a first upper bonding pad 331, among the first upper bonding pads 331, that does not correspond to (e.g., overlap) a fifth bonding pad 431.

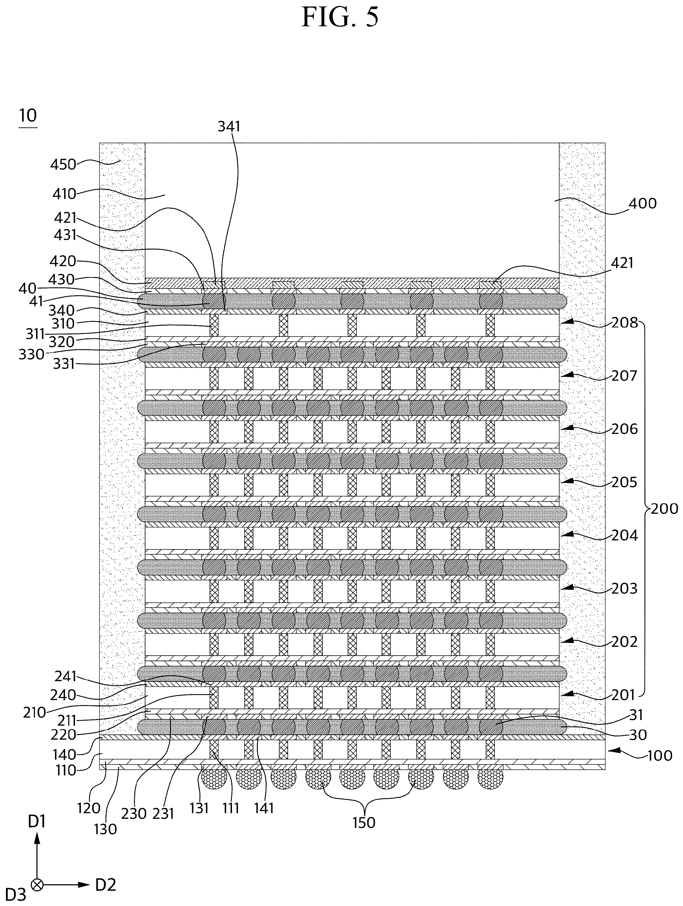

Referring to FIG. 5, the semiconductor package 10 may also include first supporting layers 30, first solder balls 31, a second supporting layer 40, and second solder balls 41. The first supporting layers 30 may be disposed between the first semiconductor chip 100 and the second semiconductor chip 201, between adjacent second semiconductor chips from the plurality of second semiconductor chips 201 to 207, and between the second semiconductor chip 207 and the upper semiconductor chip 208. As an example, a first supporting layer 30 may be disposed between the second bonding layer 140 and the third bonding layer 230 of the lowermost second semiconductor chip 201 among the plurality of second semiconductor chips 201 to 207. As another example, among adjacent second semiconductor chips from the plurality of second semiconductor chips 201 to 207, a first supporting layer 30 may be disposed between the fourth bonding layer 240 of a lower second semiconductor chip and the third bonding layer 230 of an upper second semiconductor chip. As still another example, a first supporting layer 30 may be disposed between the fourth bonding layer 240 of the second semiconductor chip 207 and the first upper bonding layer 330. For example, the first supporting layer 30 may include a non-conductive film (NCF).

The first solder balls 31 may electrically connect the first semiconductor chip 100 and the plurality of second semiconductor chips 201 to 207. As an example, each of the first solder ball 31 may be disposed between a respective one of the second bonding pads 141 and a respective one of the third bonding pads 231 of the second semiconductor chip 201. As another example, among adjacent second semiconductor chips from the plurality of second semiconductor chips 201 to 207, the first solder balls 31 may each be disposed between a respective one of the fourth bonding pads 241 of a lower second semiconductor chip and a respective one of the third bonding pads 231 of an upper second semiconductor chip. As still another example, the first solder balls 31 may each be disposed between a respective one of the fourth bonding pads 241 of the second semiconductor chip 207 and a respective one of the first upper bonding pads 331.

The second supporting layer 40 may be disposed between the upper semiconductor chip 208 and the dummy semiconductor chip 400. For example, the second supporting layer 40 may be disposed between the second upper bonding layer 340 and the dummy bonding layer 430.

The second solder balls 41 may be disposed between the second upper bonding pads 341 and the fifth bonding pads 431. The second solder ball 41 may be electrically connected to the capacitor 421 through the fifth bonding pad 431.

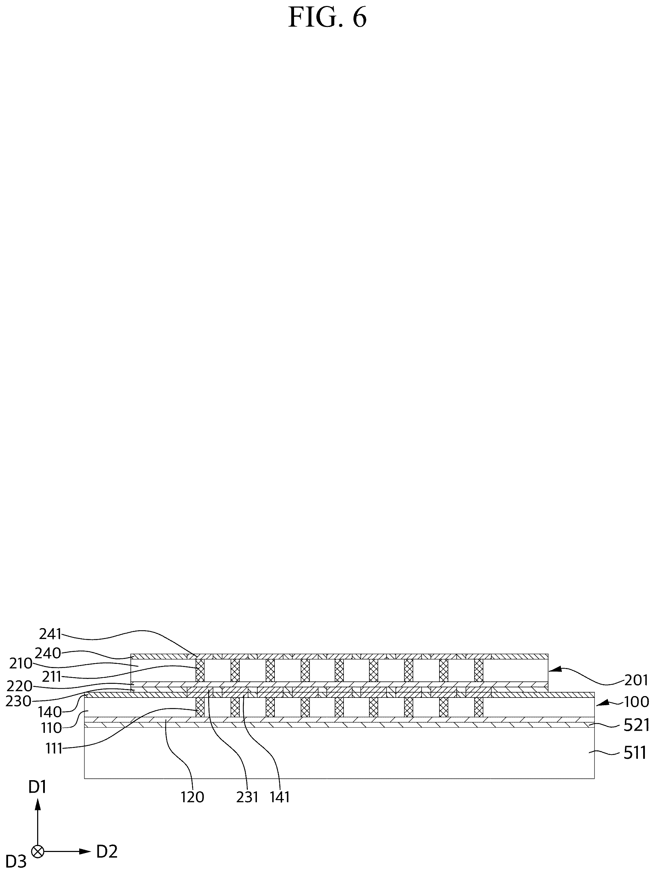

FIGS. 6 through 11 are example diagrams illustrating a manufacturing process of the semiconductor package 10 according to example embodiments.

Referring to FIG. 6, the first semiconductor chip 100 may be attached to a first release film 521 after the first release film 521 is attached to an upper surface of a first supporting substrate 511. The first semiconductor chip 100 may be attached to the first release film 521 such that the first chip wiring layer 120 faces the first supporting substrate 511.

The lowermost second semiconductor chip 201 may be disposed on the first semiconductor chip 100. The second bonding pads 141 of the first semiconductor chip 100 and the third bonding pads 231 of the second semiconductor chip 201 may be bonded together by heat and pressure.

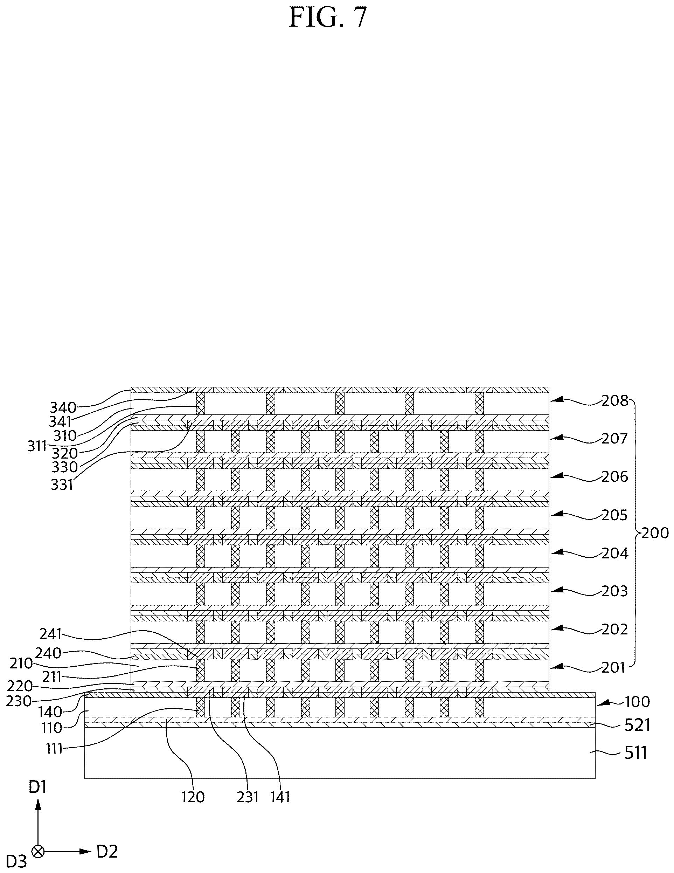

Referring to FIG. 7, the plurality of second semiconductor chips 201 to 207 may be stacked sequentially on the first semiconductor chip 100. Among adjacent second semiconductor chips from the second semiconductor chips 201 to 207, the fourth bonding pads 241 of a lower second semiconductor chip and the third bonding pads 231 of an upper second semiconductor chip may be bonded together by applying heat and pressure when being stacked.

The upper semiconductor chip 208 may be disposed on the uppermost second semiconductor chip 207. The first upper bonding pads 331 and the fourth bonding pads 241 of the uppermost second semiconductor chip 207 may be bonded together by heat and pressure.

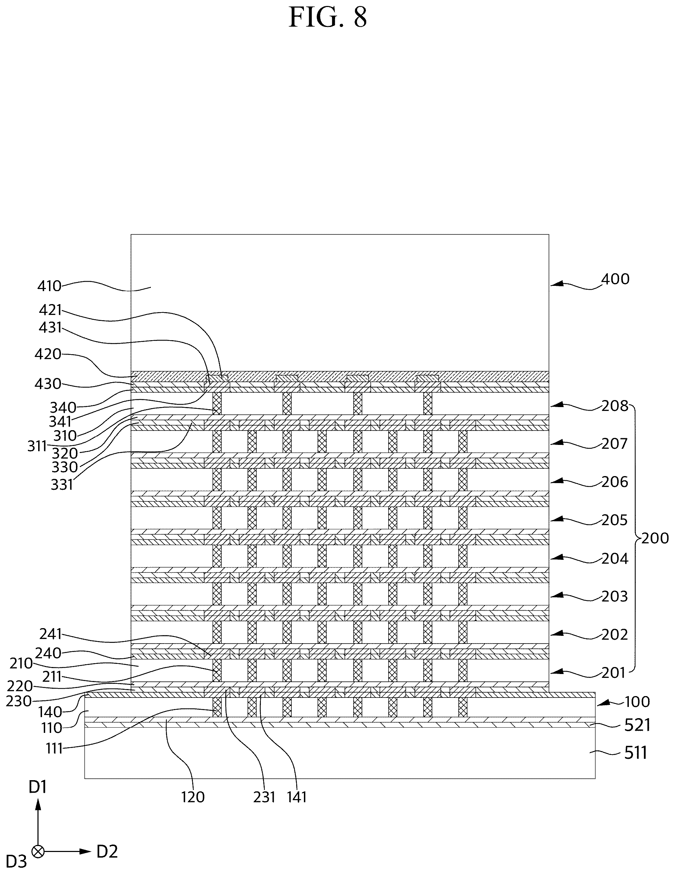

Referring to FIG. 8, the dummy semiconductor chip 400 may be stacked on the upper semiconductor chip 208. The fifth bonding pads 431 of the dummy semiconductor chip 400 and the fourth bonding pads 341 of the upper semiconductor chip 208 may be bonded together by heat and pressure.

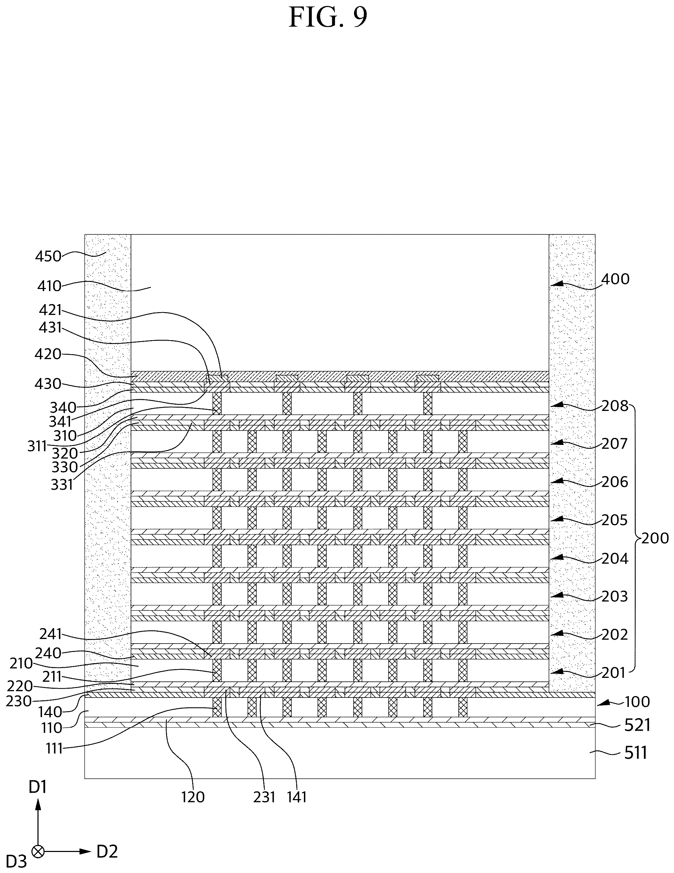

Referring to FIG. 9, the molding layer 450 may be formed to cover the upper surface of the first semiconductor chip 100 and surround side surfaces of the chip stack 200 and dummy semiconductor chip 400. Upper surfaces of the molding layer 450 and dummy semiconductor chip 400 may be aligned on the same plane, as their upper portions may be partially removed through a polishing process such as chemical mechanical polishing (CMP). The first supporting substrate 511 and the first release film 521 may be separated from the first chip wiring layer 120 after the molding layer 450 is formed.

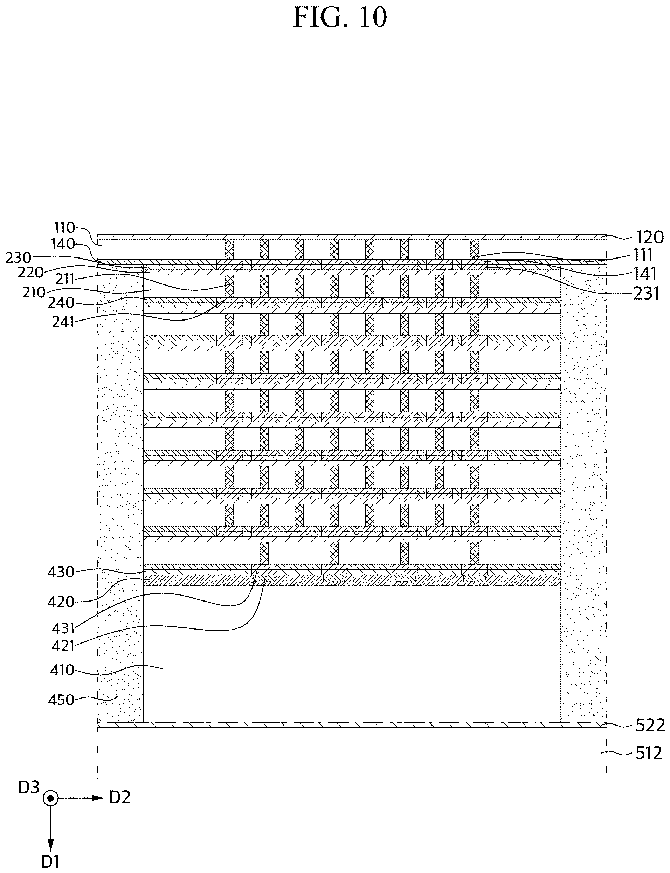

Referring to FIG. 10, the structure of FIG. 9 may be inverted, attached to a second release film 522, and bonded to a second supporting substrate 512. Upper surfaces of the dummy semiconductor substrate 410 and molding layer 450 may be bonded to the second release film 522.

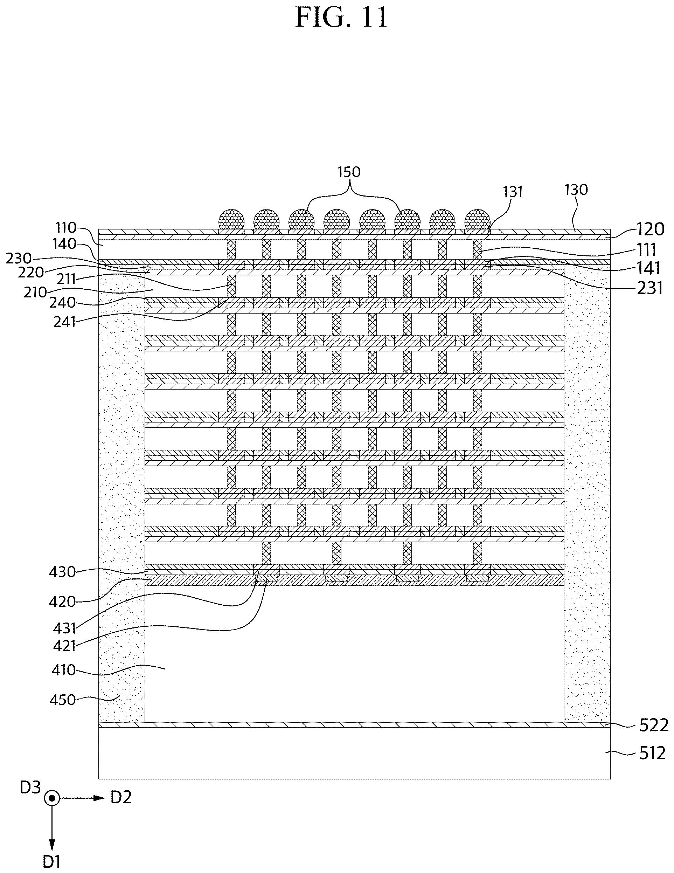

Referring to FIG. 11, the first bonding layer 130, the first bonding pads 131, and the connection terminals 150 may be formed on (e.g., above) the first chip wiring layer 120. The second supporting substrate 512 and the second release film 522 may be separated from the dummy semiconductor substrate 410 and the molding layer 450, and when the structure is inverted, the semiconductor package 10 of FIG. 1 may be formed.

Embodiments are set out in the following Clauses:
Clause 1. A semiconductor package comprising:
   a first semiconductor chip;
   a plurality of second semiconductor chips stacked on the first semiconductor chip in a first direction perpendicular to an upper surface of the first semiconductor chip;
   an upper semiconductor chip stacked on the uppermost second semiconductor chip among the plurality of second semiconductor chips; and
   a dummy semiconductor chip stacked on the upper semiconductor chip and including a capacitor,
   wherein the upper semiconductor chip comprises an upper through via electrically connected to the capacitor.
Clause 2. The semiconductor package of Clause 1, wherein
   each of the plurality of second semiconductor chips comprises:
      a second semiconductor substrate;
      a second chip wiring layer; and
      a plurality of second through vias disposed in the second semiconductor substrate, and
   wherein one of the plurality of second through vias is connected to the upper through via and the capacitor.
Clause 3. The semiconductor package of Clause 2, wherein in each of the plurality of second semiconductor chips:
   the plurality of second through vias include power/ground through vias configured to transmit a power voltage or a ground voltage, and
   the upper through via is electrically connected to at least one of the power/ground through vias.
Clause 4. The semiconductor package of Clause 2 or Clause 3, wherein in each second semiconductor chip of the plurality of second semiconductor chips the plurality of second through vias further include a signal through via configured to transmit information.
Clause 5. The semiconductor package of any of Clauses 2-4,
   wherein the first semiconductor chip comprises:
      a first semiconductor substrate;
      a first bonding layer on a lower surface of the first semiconductor substrate;
      a second bonding layer on an upper surface of the first semiconductor substrate; and
      a plurality of first through vias disposed in the first semiconductor substrate, and
   wherein a first through via of the plurality of first through vias is a power first through via electrically connected to the capacitor through at least one of the power/ground through vias.
Clause 6. The semiconductor package of Clause 5, further comprising:
   a connection terminal disposed on a lower surface of the first bonding layer of the first semiconductor chip,
   wherein the connection terminal is electrically connected to the capacitor through the power first through via, at least one of the power/ground through vias, and the upper through via.
Clause 7. The semiconductor package of Clause 6,
   wherein the first semiconductor chip further comprises:
      a first bonding pad bonded to the connection terminal; and
      a second bonding pad bonded to the lowermost second semiconductor chip among the plurality of second semiconductor chips, and
   wherein each second semiconductor chip of the plurality of second semiconductor chips further comprises:
      a third bonding layer on a lower surface of the second semiconductor chip;
      a fourth bonding layer on an upper surface of the second semiconductor chip;
      a third bonding pad bonded to a corresponding one of the plurality of second through vias; and
      a fourth bonding pad bonded to the respective second through via.
Clause 8. The semiconductor package of Clause 7, wherein the upper semiconductor chip further comprises:
   an upper semiconductor substrate surrounding the upper through via;
   a first upper bonding layer in contact with the uppermost second semiconductor chip among the plurality of second semiconductor chips;
   a second upper bonding layer in contact with the dummy semiconductor chip;
   a first upper bonding pad bonded to the fourth bonding pad of the uppermost second semiconductor chip among the plurality of second semiconductor chips; and
   a second upper bonding pad overlapping with the upper through via in the first direction.
Clause 9. The semiconductor package of any of Clauses 2-7, wherein the upper semiconductor chip further comprises:
   an upper semiconductor substrate surrounding the upper through via;
   a first upper bonding layer in contact with the uppermost second semiconductor chip among the plurality of second semiconductor chips;
   a second upper bonding layer in contact with the dummy semiconductor chip;
   a plurality of first upper bonding pads, each of the plurality of first upper bonding pads overlapping with a corresponding one the plurality of second through vias in the first direction;
   a plurality of second upper bonding pads disposed between the upper through via and the capacitor; and
   a first dummy bonding pad bonded to one of the plurality of first upper bonding pads between two adjacent second upper bonding pads of the plurality of second upper bonding pads.
Clause 10. The semiconductor package of Clause 9, wherein the dummy semiconductor chip further comprises:
   a dummy semiconductor substrate disposed above the upper semiconductor chip;
   an upper wiring layer disposed below the dummy semiconductor substrate and in which the capacitor is disposed;
   a dummy bonding layer disposed below the upper wiring layer;
   a fifth bonding pad overlapping with one of the plurality of second upper bonding pads in the first direction; and
   a second dummy bonding pad overlapping with the first dummy bonding pad in the first direction.
Clause 11. The semiconductor package of any preceding Clause, further comprising a molding layer surrounding the plurality of second semiconductor chips, the upper semiconductor chip, and the dummy semiconductor chip.
Clause 12. The semiconductor package of any preceding Clause, wherein a thickness in the first direction of each of the plurality of second semiconductor chips is the same.
Clause 13. The semiconductor package of Clause 12, wherein a thickness in the first direction of the upper semiconductor chip is the same as the thickness in the first direction of each of the plurality of second semiconductor chips.
Clause 14. A semiconductor package comprising:
   a first semiconductor chip;
   a plurality of second semiconductor chips stacked on the first semiconductor chip in a first direction perpendicular to an upper surface of the first semiconductor chip;
   a connection terminal disposed on a lower surface of the first semiconductor chip;
   an upper semiconductor chip stacked on the uppermost second semiconductor chip among the plurality of second semiconductor chips;
   a dummy semiconductor chip stacked on the upper semiconductor chip and including a capacitor; and
   a molding layer surrounding the plurality of second semiconductor chips, the upper semiconductor chip, and the dummy semiconductor chip,
   wherein each of the plurality of second semiconductor chips comprises a plurality of second through vias including power/ground through vias configured to transmit a power voltage or a ground voltage between the first semiconductor chip and the plurality of second semiconductor chips, and
   wherein the upper semiconductor chip comprises an upper semiconductor substrate and an upper through via electrically connected to the power through via and disposed in the upper semiconductor substrate, and
   wherein the capacitor is electrically connected to the upper through via.
Clause 15. The semiconductor package of Clause 14, wherein in each of the plurality of second semiconductor chips the plurality of second through vias further comprise a signal through via configured to transmit information.

While the present disclosure has been described in detail in connection with above example embodiments, however, the scope of the present disclosure is not limited to thereto and it is to be understood by those skilled in the art that the present disclosure is intended to cover various modifications and equivalent arrangements within the scope of the appended claims. In addition, the above-described example embodiments may be implemented with some elements thereof removed, and each example embodiment may be implemented.

## Claims

1. A semiconductor package comprising:
a first semiconductor chip (100);
a plurality of second semiconductor chips (201-207) stacked on the first semiconductor chip (100) in a first direction perpendicular to an upper surface of the first semiconductor chip (100);
an upper semiconductor chip (208) stacked on the uppermost second semiconductor chip among the plurality of second semiconductor chips (201-207); and
a dummy semiconductor chip (400) stacked on the upper semiconductor chip (208) and including a capacitor (421),
wherein the upper semiconductor chip (208) comprises an upper through via (311) electrically connected to the capacitor (421).

2. The semiconductor package of claim 1, wherein
each of the plurality of second semiconductor chips (201-207) comprises:
a second semiconductor substrate (210);
a second chip wiring layer (220); and
a plurality of second through vias (211) disposed in the second semiconductor substrate (210), and
wherein one of the plurality of second through vias (211) is connected to the upper through via (311) and the capacitor (421).

3. The semiconductor package of claim 2, wherein in each of the plurality of second semiconductor chips (201-207):
the plurality of second through vias (211) include power/ground through vias configured to transmit a power voltage or a ground voltage, and
the upper through via (311) is electrically connected to at least one of the power/ground through vias.

4. The semiconductor package of claim 2 or claim 3, wherein in each second semiconductor chip of the plurality of second semiconductor chips (201-207) the plurality of second through vias (211) further include a signal through via configured to transmit information.

5. The semiconductor package of any of claims 2-4,
wherein the first semiconductor chip (100) comprises:
a first semiconductor substrate (110);
a first bonding layer (130) on a lower surface of the first semiconductor substrate (110);
a second bonding layer (140) on an upper surface of the first semiconductor substrate (110); and
a plurality of first through vias (111) disposed in the first semiconductor substrate (110), and
wherein a first through via of the plurality of first through vias (111) is a power first through via electrically connected to the capacitor (421) through at least one of the power/ground through vias.

6. The semiconductor package of claim 5, further comprising:
a connection terminal (150) disposed on a lower surface of the first bonding layer (130) of the first semiconductor chip (100),
wherein the connection terminal (150) is electrically connected to the capacitor (421) through the power first through via, at least one of the power/ground through vias, and the upper through via (311).

7. The semiconductor package of claim 6,
wherein the first semiconductor chip (100) further comprises:
a first bonding pad (131) bonded to the connection terminal (150); and
a second bonding pad bonded (141) to the lowermost second semiconductor chip (201) among the plurality of second semiconductor chips (201-207), and
wherein each second semiconductor chip of the plurality of second semiconductor chips (201-207) further comprises:
a third bonding layer (230) on a lower surface of the second semiconductor substrate (210);
a fourth bonding layer (240) on an upper surface of the second semiconductor substrate (210);
a third bonding pad (231) bonded to a corresponding one of the plurality of second through vias (211); and
a fourth bonding pad (241) bonded to the corresponding one of the plurality of second through vias (211).

8. The semiconductor package of claim 7, wherein the upper semiconductor chip (208) further comprises:
an upper semiconductor substrate (310) surrounding the upper through via (311);
a first upper bonding layer (330) in contact with the uppermost second semiconductor chip (207) among the plurality of second semiconductor chips (201-207);
a second upper bonding layer (340) in contact with the dummy semiconductor chip (400);
a first upper bonding pad (331) bonded to the fourth bonding pad (241) of the uppermost second semiconductor chip (207) among the plurality of second semiconductor chips (201-207); and
a second upper bonding pad (341) overlapping with the upper through via (311) in the first direction.

9. The semiconductor package of any of claims 2-7, wherein the upper semiconductor chip (207) further comprises:
an upper semiconductor substrate (310) surrounding the upper through via (311);
a first upper bonding layer (330) in contact with the uppermost second semiconductor chip (207) among the plurality of second semiconductor chips (201-207);
a second upper bonding layer (340) in contact with the dummy semiconductor chip (400);
a plurality of first upper bonding pads (331), each of the plurality of first upper bonding pads (331) overlapping with a corresponding one the plurality of second through vias (211) in the first direction;
a plurality of second upper bonding pads (341) disposed between the upper through via (311) and the capacitor (421); and
a first dummy bonding pad (341a) corresponding to one of the plurality of first upper bonding pads (331) between two adjacent second upper bonding pads of the plurality of second upper bonding pads (341).

10. The semiconductor package of claim 9, wherein the dummy semiconductor chip (400) further comprises:
a dummy semiconductor substrate (410) disposed above the upper semiconductor chip (208);
an upper wiring layer (420) disposed below the dummy semiconductor substrate (410) and in which the capacitor is disposed (421);
a dummy bonding layer (430) disposed below the upper wiring layer (420);
a fifth bonding pad (431) overlapping with one of the plurality of second upper bonding pads (341) in the first direction; and
a second dummy bonding pad (431a) overlapping with the first dummy bonding pad (341a) in the first direction.

11. The semiconductor package of any preceding claim, further comprising a molding layer (450) surrounding the plurality of second semiconductor chips (201-207), the upper semiconductor chip (208), and the dummy semiconductor chip (400).

12. The semiconductor package of any preceding claim, wherein a thickness in the first direction of each of the plurality of second semiconductor chips (201-207) is the same.

13. The semiconductor package of claim 12, wherein a thickness in the first direction of the upper semiconductor chip (208) is the same as the thickness in the first direction of each of the plurality of second semiconductor chips (201-207).

14. The semiconductor package of claim 1 further comprising:
a connection terminal (150) disposed on a lower surface of the first semiconductor chip (100); and
a molding layer surrounding the plurality of second semiconductor chips, the upper semiconductor chip, and the dummy semiconductor chip,
wherein each of the plurality of second semiconductor chips (201-207) comprises a plurality of second through vias (211) including power/ground through vias configured to transmit a power voltage or a ground voltage between the first semiconductor chip (100) and the plurality of second semiconductor chips (201-207), and
wherein the upper semiconductor chip (208) comprises an upper semiconductor substrate (310) and an upper through via (311) electrically connected to at least one of the power/ground through vias and disposed in the upper semiconductor substrate (310).

15. The semiconductor package of claim 14, wherein in each of the plurality of second semiconductor chips (201-207) the plurality of second through vias (211) further comprise a signal through via configured to transmit information.
